(19) Europäisches Patentamt
European Patent Office
Office européen des brevets

(11) **EP 2 533 538 A2**

(12) **EUROPEAN PATENT APPLICATION**

(43) Date of publication:
**12.12.2012 Bulletin 2012/50**

(51) Int Cl.:
**H04N 7/26** (2006.01)          **H04N 7/50** (2006.01)
**H03M 7/40** (2006.01)

(21) Application number: **12171253.3**

(22) Date of filing: **08.06.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **10.06.2011   US 201161495772 P**

(71) Applicant: **Research In Motion Limited**
**Waterloo, ON N2L 3W8 (CA)**

(72) Inventor: **He, Dake**
**Waterloo, Ontario N2L 3W8 (CA)**

(74) Representative: **Patel, Binesh**
**Barker Brettell LLP**
**100 Hagley Road**
**Edgbaston**
**Birmingham**
**B16 8QQ (GB)**

(54)    **Method and system to reduce modelling overhead for data compression**

(57)    A method for decoding compressed data that has been encoded using a context model, each context having a context state corresponding to a probability estimate. Each bin of the data has been encoded using the probability estimate corresponding to the context state for the context associated with that bin. At the decoder, for decoding a series of bins associated with a given context, an initial probability estimate is determined using an initial context state for the given context and the series of bins are decoded and reconstructed using that initial probability estimate. After the series is decoded, the context state is updated based on the reconstructed bins for the series to produce an updated context state for that context to be used in decoding a subsequence portion of the bitstream.

Quantize sequence *y* to obtain quantized sequence *x*    — 202

Scan *x* to find context for each bin symbol in *x* and, for each context represented in the sequence *x*, count the total number of symbols and the number of LPS sysmbols    — 204

Determine the initial probability estimate for each context based on the counts for that context    — 206

Encode the sequence based on associated context and initial probability estimates    — 208

Insert count information into the bitstream    — 210

_**FIG. 4**_

**Description**

**CROSS-REFERENCE TO RELATED APPLICATIONS**

The present application claims priority to US patent application serial no. 61/495,772, filed June 10, 2011, and owned in common herewith, the contents of which are hereby incorporated by reference.

**FIELD**

The present application generally relates to data compression and, in particular, to an encoder, a decoder and methods of coding and decoding using a context-based coding order.

**BACKGROUND**

Data compression, whether lossy or lossless, often uses entropy coding to encode a decorrelated signal as a sequence of bits, i.e. a bitstream. Efficient data compression has a wide range of applications, such as image, audio, and video encoding. The current state-of-the-art for video encoding is the ITU-T H.264/MPEG AVC video coding standard. It defines a number of different profiles for different applications, including the Main profile, Baseline profile and others. A next-generation video encoding standard is currently under development through a joint initiative of MPEG-ITU: High Efficiency Video Coding (HEVC).

There are a number of standards for encoding/decoding images and videos, including H.264, that employs lossy compression processes to produce binary data. For example, H.264 includes a prediction operation to obtain residual data, followed by atransform approximating a discrete cosine transform (DCT) and quantization of the transform coefficients. The resulting data, including quantized coefficients, motion vectors, coding mode, and other related data, is then entropy coded to generate a bitstream of data for transmission or storage on a computer-readable medium. It is expected that HEVC will also have these features.

A number of coding schemes have been developed to encode the data output from a process similar to the one described above. For example, JPEG images may be encoded using Huffman codes. The H.264 standard allows for two possible entropy coding processes: Context Adaptive Variable Length Coding (CAVLC) or Context Adaptive Binary Arithmetic Coding (CABAC). CABAC results in greater compression than CAVLC, but CABAC is more computationally demanding. In CABAC, the coding scheme operates upon the binary data to produce a serial bitstream of encoded data. At the decoder, the decoding scheme receives the bitstream and entropy decodes the serial bitstream to reconstruct the binary data.

It would be advantageous to provide for an improved encoder, decoder and method of entropy coding and decoding.

**BRIEF SUMMARY**

The present application describes devices, methods and processes for encoding and decoding binary data.

In one aspect, the present application describes methods of encoding an input sequence of symbols using empirical probability estimates.

In another aspect, the present application describes an encoder for encoding an input sequence of symbols. The encoder includes a processor; memory; and an encoding application stored in memory and containing instructions for configuring the processor to encode the input sequence in accordance with one of the methods described herein.

In yet another aspect, the present application describes methods of decoding a bitstream of encoded data using empirical bin symbol count information.

In yet a further aspect, the present application describes a decoder for decoding encoded data for decoding a bitstream of encoded data to reconstruct a sequence of symbols. The decoder includes a processor; memory; and a decoding application stored in memory and containing instructions for configuring the processor to decode the bitstream in accordance with one of the methods described herein.

In yet a further aspect, the present application describes computer-readable media storing computer-executable program instructions which, when executed, configured a processor to perform the described methods of encoding and/or decoding.

In another aspect, the present application describes a two-pass encoding process. In one aspect, the two-pass encoding process for encoding a digital input using a context model that defines a plurality of contexts. The process includes, for a sequence of bits from the digital input, determining a context for each bit in the sequence of bits; determining a count of most probable symbols and least probable symbols for each context represented in the sequence of bits; entropy encoding each bit using its context and a probability estimate based on the count of most probable symbols and least probable symbols for that context to produce a bitstream of encoded data; and inserting information regarding the count for each context in the bitstream.

In a further aspect, the present application describes a process for decoding encoded data using count information. The process is for decoding a bitstream of encoded data, wherein the encoded data has been encoded in accordance with a context model that defines a plurality of contexts. The process includes obtaining information from the bitstream regarding a count of most probable symbols and least probable symbols for each context represented in a sequence of bits; and reconstructing the sequence of bits by, for each bit, determining a context and a probability estimate, wherein the probability estimate is based upon the count of most probable symbols and least probable symbols for that context, and entropy decoding that bit from the bitstream using the determined context and the probability estimate.

In yet another aspect, the present application describes a method for decoding a bitstream of encoded video data based on count information in a video decoder, wherein the encoded video data has been encoded in accordance with a context model that defines a plurality of contexts. The method includes obtaining information from the bitstream regarding a count of symbols for each context represented in a sequence of bits; and reconstructing the sequence of bits by, for each bit, determining a context and a probability estimate, wherein the probability estimate is based upon the count of symbols for that context, and entropy decoding that bit from the bitstream using the determined context and the determined probability estimate.

In a further aspect, the present application describes a method for encoding video data in a video encoder using a context model that defines a plurality of contexts. The method includes, for a sequence of bits from the video data, determining a context for each bit in the sequence of bits; determining a count of symbols for each context represented in the sequence of bits; entropy encoding each bit using its context and a probability estimate based on the count of symbols for that context to produce a bitstream of encoded data; and inserting information in the bitstream regarding the count for each context within the sequence of bits.

In another aspect, the present application provides a method for decoding a bitstream of encoded data that has been encoded in accordance with a context model that defines a plurality of contexts, each context having a set of probability states, each bin of the encoded data having been encoded based upon its associated context and one of the probability states for that context. The method includes, for a current part of the bitstream, and for a context associated with a plurality of bins contained in the current part, determining an initial probability estimate based upon an initial probability state for that context; decoding the current part using the initial probability state to reconstruct the bins associated with that context; and updating the initial probability state of the context based on the reconstructed bins associated with that context to produce an updated probability state.

In another aspect, the present application describes a method for encoding data in accordance with a context model that defines a plurality of contexts, each context having a set of probability states. The method includes, for a sequence of the data and for a context associated with a plurality of bins contained in the sequence, determining an initial probability state for that context; encoding the plurality of bins associated with that context using the initial probability state to generate a bitstream of encoded data; and updating the initial probability state of the context based on the values of the bins associated with that context to produce an updated probability state.

In yet a further aspect, the present application describes a method for decoding a bitstream of encoded data that has been encoded in accordance with a context model that defines a plurality of contexts, each context having a probability state, each bin of the encoded data having been encoded based upon its associated context and the probability state of that context. The method includes, for a part of the bitstream having a plurality of bins, decoding each bin in the part by deriving the context associated with the bin, and decoding the bin using the probability state of the context; and updating the probability state of each context based on the decoded bins associated with that context.

Other aspects and features of the present application will be understood by those of ordinary skill in the art from a review of the following description of examples in conjunction with the accompanying figures.

## BRIEF DESCRIPTION OF THE DRAWINGS

Reference will now be made, by way of example, to the accompanying drawings which show example embodiments of the present application, and in which:

Figure 1 shows, in block diagram form, an encoder for encoding video;

Figure 2 shows, in block diagram form, a decoder for decoding video;

Figure 3 shows a block diagram of an encoding process;

Figure 4 shows an example two-pass encoding process;

Figure 5 shows a flowchart of an example decoding process;

Figure 6 shows, in flowchart form, another example of a decoding process;

Figure 7 shows a simplified block diagram of an example embodiment of an encoder; and

Figure 8 shows a simplified block diagram of an example embodiment of a decoder.

Similar reference numerals may have been used in different figures to denote similar components.

**DESCRIPTION OF EXAMPLE EMBODIMENTS**

The following description relates to data compression in general and, in particular, to the efficient encoding and decoding of finite alphabet sources, such as binary sources. In many of the examples given below, particular applications of such an encoding and decoding scheme are given. For example, many of the illustrations below make reference to video coding. It will be appreciated that the present application is not necessarily limited to video coding or image coding. It may be applicable to the any type of data subject to a context-based encoding scheme.

The example embodiments described herein relate to data compression of a finite alphabet source. Accordingly, the description often makes reference to "symbols", which are the elements of the alphabet. In some cases, the description herein refers to binary sources, and refers to the symbols as bits or bins. At times, the terms "symbol", "bit", and/or "bin" may be used interchangeably for a given example. It will be appreciated that a binary source is but one example of a finite alphabet source. The present application is not necessarily limited to binary sources.

In the description that follows, example embodiments are described with reference to the H.264 standard. Those ordinarily skilled in the art will understand that the present application is not limited to H.264 but may be applicable to other video coding/decoding standards, including possible future standards, such as HEVC. It will also be appreciated that the present application is not necessarily limited to video coding/decoding and may be applicable to coding/decoding of any finite alphabet sources.

In the description that follows, in the context of video applications reference is made to a number of portions of a video, including a group-of-pictures, a frame, a slice, a macroblock, a transform block, a coding unit, a transform unit, a coefficient group, etc. Those of skill in the art will appreciate that, in the case of the H.264 standard, a frame may contain one or more slices. It will also be appreciated that certain encoding/decoding operations are performed on a frame-by-frame basis, a slice-by-slice basis, a macroblock or coding unit basis, a transform block/unit basis, or a coefficient group basis, depending on the particular requirements of the applicable video coding standard. In any particular embodiment, the applicable video coding standard may determine on what basis the operations described below are performed. Accordingly, those ordinarily skilled in the art will understand, in light of the present disclosure, whether particular operations or processes described herein and particular references to frames, slices, blocks, units are applicable to frames, slices, blocks, units, or any of them, for a given embodiment.

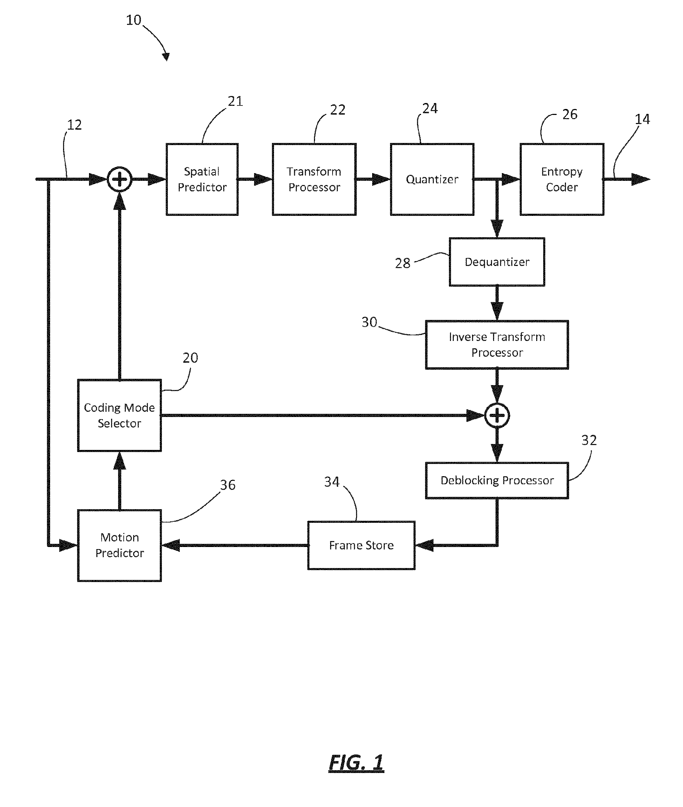

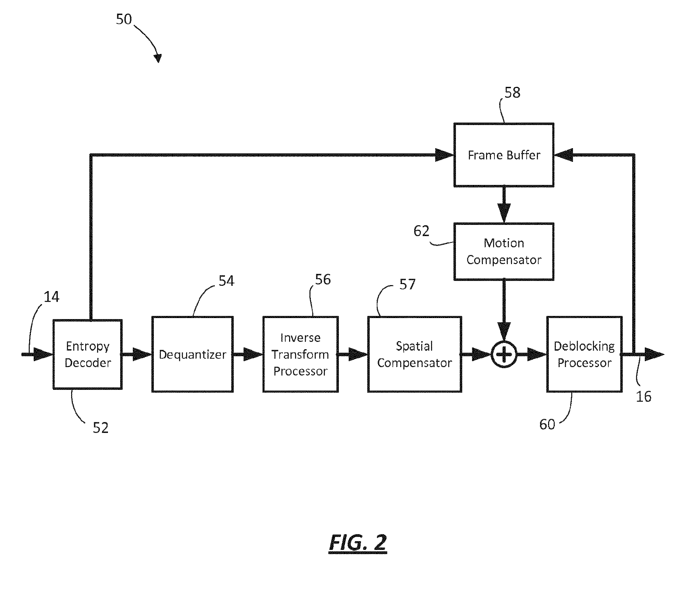

Reference is now made to Figure 1, which shows, in block diagram form, an encoder 10 for encoding video. Reference is also made to Figure 2, which shows a block diagram of a decoder 50 for decoding video. It will be appreciated that the encoder 10 and decoder 50 described herein may each be implemented on an application-specific or general purpose computing device, containing one or more processing elements and memory. The operations performed by the encoder 10 or decoder 50, as the case may be, may be implemented by way of application-specific integrated circuit, for example, or by way of stored program instructions executable by a general purpose processor. The device may include additional software, including, for example, an operating system for controlling basic device functions. The range of devices and platforms within which the encoder 10 or decoder 50 may be implemented will be appreciated by those ordinarily skilled in the art having regard to the following description.

The encoder 10 receives a video source 12 and produces an encoded bitstream 14. The decoder 50 receives the encoded bitstream 14 and outputs a decoded video frame 16. The encoder 10 and decoder 50 may be configured to operate in conformance with a number of video compression standards. For example, the encoder 10 and decoder 50 may be H.264/AVC compliant. In other embodiments, the encoder 10 and decoder 50 may conform to other video compression standards, including evolutions of the H.264/AVC standard.

The encoder 10 includes a spatial predictor 21, a coding mode selector 20, transform processor 22, quantizer 24, and entropy coder 26. As will be appreciated by those ordinarily skilled in the art, the coding mode selector 20 determines the appropriate coding mode for the video source, for example whether the subject frame/slice is of I, P, or B type, and whether particular macroblocks or coding units within the frame/slice are inter or intra coded. The transform processor 22 performs a transform upon the spatial domain data. In particular, the transform processor 22 applies a block-based transform to convert spatial domain data to spectral components. For example, in many embodiments a discrete cosine transform (DCT) is used. Other transforms, such as a discrete sine transform or others may be used in some instances. Applying the block-based transform to a block of pixel data results in a set of transform domain coefficients. The set of transform domain coefficients is quantized by the quantizer 24. The quantized coefficients and associated information, such as motion vectors, quantization parameters, etc., are then encoded by the entropy coder 26.

Intra-coded frames/slices (i.e. type I) are encoded without reference to other frames/slices. In other words, they do not employ temporal prediction. However intra-coded frames do rely upon spatial prediction within the frame/slice, as illustrated in Figure 1 by the spatial predictor 21. That is, when encoding a particular block the data in the block may be compared to the data of nearby pixels within blocks already encoded for that frame/slice. Using a prediction algorithm, the source data of the block may be converted to residual data. The transform processor 22 then encodes the residual data. H.264, for example, prescribes nine spatial prediction modes for 4x4 transform blocks. In some embodiments, each of the nine modes may be used to independently process a block, and then rate-distortion optimization is used to select the best mode.

The H.264 standard also prescribes the use of motion prediction/compensation to take advantage of temporal prediction. Accordingly, the encoder 10 has a feedback loop that includes a de-quantizer 28, inverse transform processor 30, and deblocking processor 32. These elements mirror the decoding process implemented by the decoder 50 to reproduce the frame/slice. A frame store 34 is used to store the reproduced frames. In this manner, the motion prediction is based on what will be the reconstructed frames at the decoder 50 and not on the original frames, which may differ from the reconstructed frames due to the lossy compression involved in encoding/decoding. A motion predictor 36 uses the frames/slices stored in the frame store 34 as source frames/slices for comparison to a current frame for the purpose of identifying similar blocks. Accordingly, for macroblocks to which motion prediction is applied, the "source data" which the transform processor 22 encodes is the residual data that comes out of the motion prediction process. The residual data is pixel data that represents the differences (if any) between the reference block and the current block. Information regarding the reference frame and/or motion vector may not be processed by the transform processor 22 and/or quantizer 24, but instead may be supplied to the entropy coder 26 for encoding as part of the bitstream along with the quantized coefficients.

Those ordinarily skilled in the art will appreciate the details and possible variations for implementing H.264 encoders.

The decoder 50 includes an entropy decoder 52, dequantizer 54, inverse transform processor 56, spatial compensator 57, and deblocking processor 60. A frame buffer 58 supplies reconstructed frames for use by a motion compensator 62 in applying motion compensation. The spatial compensator 57 represents the operation of recovering the video data for a particular intra-coded block from a previously decoded block.

The bitstream 14 is received and decoded by the entropy decoder 52 to recover the quantized coefficients. Side information may also be recovered during the entropy decoding process, some of which may be supplied to the motion compensation loop for use in motion compensation, if applicable. For example, the entropy decoder 52 may recover motion vectors and/or reference frame information for inter-coded macroblocks.

The quantized coefficients are then dequantized by the dequantizer 54 to produce the transform domain coefficients, which are then subjected to an inverse transform by the inverse transform processor 56 to recreate the "video data". It will be appreciated that, in some cases, such as with an intra-coded macroblock, the recreated "video data" is the residual data for use in spatial compensation relative to a previously decoded block within the frame. The spatial compensator 57 generates the video data from the residual data and pixel data from a previously decoded block. In other cases, such as inter-coded macroblocks, the recreated "video data" from the inverse transform processor 56 is the residual data for use in motion compensation relative to a reference block from a different frame. Both spatial and motion compensation may be referred to herein as "prediction operations".

The motion compensator 62 locates a reference block within the frame buffer 58 specified for a particular inter-coded macroblock. It does so based on the reference frame information and motion vector specified for the inter-coded macroblock. It then supplies the reference block pixel data for combination with the residual data to arrive at the recreated video data for that macroblock.

A deblocking process may then be applied to a reconstructed frame/slice, as indicated by the deblocking processor 60. After deblocking, the frame/slice is output as the decoded video frame 16, for example for display on a display device. It will be understood that the video playback machine, such as a computer, set-top box, DVD or Blu-Ray player, and/or mobile handheld device, may buffer decoded frames in a memory prior to display on an output device.

Entropy coding is a fundamental part of all lossless and lossy compression schemes, including the video compression described above. The purpose of entropy coding is to represent a presumably decorrelated signal, often modelled by an independent, but not identically distributed process, as a sequence of bits. The technique used to achieve this must not depend on how the decorrelated signal was generated, but may rely upon relevant probability estimations for each upcoming symbol.

There are two common approaches for entropy coding used in practice: the first one is variable-length coding, which identifies input symbols or input sequences by codewords, and the second one is range (or arithmetic) coding, which encapsulates a sequence of subintervals of the [0, 1) interval, to arrive at a single interval, from which the original sequence can be reconstructed using the probability distributions that defined those intervals. Typically, range coding methods tend to offer better compression, while VLC methods have the potential to be faster. In either case, the symbols of the input sequence are from a finite alphabet.

A special case of entropy coding is when the input alphabet is restricted to binary symbols. Here VLC schemes must group input symbols together to have any potential for compression, but since the probability distribution can change after each bit, efficient code construction is difficult. Accordingly, range encoding is considered to have greater compression due to its greater flexibility, but practical applications are hindered by the higher computational requirements of arithmetic codes.

A common challenge for both of these encoding approaches is that they are serial in nature. In some important practical applications, such as high-quality video decoding, the entropy decoder has to reach very high output speed, which can pose a problem for devices with limited processing power or speed.

One of the techniques used together with some entropy coding schemes, such as CAVLC and CABAC, both of which are used in H.264/AVC, is context modeling. With context modeling, each bit of the input sequence has a context, where the context may be given by a certain subset of the other bits, such as the bits that preceded it, or side information, or both. In a first-order context model, the context may depend entirely upon the previous bit (symbol). In many cases, the context models may be adaptive, such that the probabilities associated with symbols for a given context may change as further bits of the sequence are processed. In yet other cases, the context of a given bit may depend upon its position in the sequence, e.g. the position or ordinal of a coefficient in a matrix or block of coefficients.

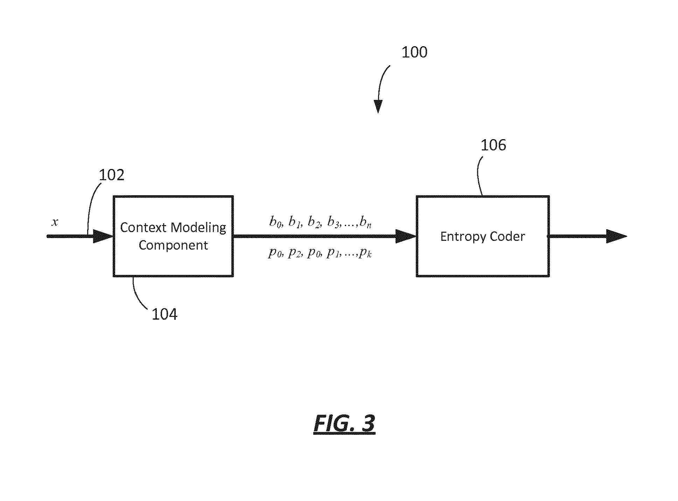

Reference is made to Figure 3, which shows a block diagram of an example encoding process 100. The encoding process 100 includes a context modeling component 104 and an entropy coder 106. The context modeling component 104 receives the input sequence x 102, which in this example is a bit sequence $(b_0, b_1, ..., b_n)$. In this example illustration, the context modeling component 104 determines a context for each bit $b_i$, perhaps based on one or more previous bits in the sequence or based on side information, and determines, based on the context, a probability $p_i$ associated with that bit $b_i$, where the probability is the probability that the bit will be the Least Probable Symbol (LPS). The LPS may be "0" or "1" in a binary embodiment, depending on the convention or application. The determination of the probability may itself depend upon the previous bits/symbols for that same context.

The context modeling component outputs the input sequence, *i.e.* the bits $(b_0, b_1, ..., b_n)$ along with their respective probabilities $(p_0, p_1, ..., p_n)$. The probabilities are an estimated probability determined by the context model. This data is then input to the entropy coder 106, which encodes the input sequence using the probability information. For example, the entropy coder 106 may be a binary arithmetic coder. The entropy coder 106 outputs a bitstream 108 of encoded data.

It will be appreciated each bit of the input sequence is processed serially to update the context model, and the serial bits and probability information are supplied to the entropy coder 106, which then serially entropy codes the bits to create the bitstream 108. Those ordinarily skilled in the art will appreciate that, in some embodiments, explicit probability information may not be passed from the context modeling component 104 to the entropy coder 106; rather, in some instances, for each bit the context modeling component 104 may send the entropy coder 106 an index or other indicator that reflects the probability estimation made by the context modeling component 104 based on the context model and the current context of the input sequence 102. The index or other indicator is indicative of the probability estimate associated with its corresponding bit.

At the decoder, the encoded bitstream is decoded using a reverse process. In particular, the decoder performs the same context modeling and probability estimation process to determine the context of the next reconstructed symbol of the reconstructed sequence. On the basis of the context determined for the next reconstructed symbol, an estimated probability is determined. The encoded bitstream, which may be made up of codewords output by the entropy coder(s), is decoded to obtain decoded symbols. The determination of context/probability is interleaved with the decoding of the bitstream to obtain decoded symbols corresponding to those estimate probabilities. As with the encoding process, the context model may be updated with each decoded bit.

In many cases, the modeling step of determining the estimated probability for a certain bin from a sequence is based upon an initially assumed probability distribution. This probability estimate may be updated adaptively as bins are processed so that it begins to more accurately reflect the sequence. This is commonly referred to as "one-pass" encoding. There are many practical methods for one-pass adaptive modeling. For example, a Laplace estimator, a KT (Krichevsky-Trofimov) estimator, or a finite state machine (FSM), may be used.

In general, the one-pass encoding process may be described as follows:

1. Quantize sequence y to obtain quantized sequence x

2. Losslessly compress x using a given context model.

Assume that the quantized sequence x is (or is converted to) a binary sequence $b_0b_1b_2...b_{n-1}$. Then operation 2 may be further describe as follows:

2.1 Determine the context $c_i$ of each bin $b_i$ in *x*.

2.2 Determine the estimated probability $p_i$ for symbol 1 (or 0, depending on the convention for LPS) from the context $c_i$ and the history of bins $x_0x_1...x_{i-1}$ in *x* that also have context $c_i$.

2.3 Encode $b_i$ with $p_i$ by using, for example, Huffman coding, arithmetic coding, V2V (variable-to-variable) coding, or other entropy encoding schemes.

Operation 2.2 above reflects the "one-pass" modeling approach. The initial distribution for each context $c_i$ is assumed to be uniform initially. As bins for that context are processed, the probability estimate is updated based on the bin history. As an example, assume a given context has a history of j-1 bins and, out of the j-1 bins, $m_i$ bins were 1's. Then using a Laplace estimator, the probability estimate $p_i$ for the $j^{th}$ bin is given by:

$$p_i = (m_i + 1)/(j + 2)$$

Using the same example, a KT estimator would give a probability estimate $p_i$ of:

$$p_i = (m_i + 1/2)/(j+1)$$

In another example, the probability estimate $p_i$ may be determined using a finite state machine, such as the 64 probability states defined in CABAC of the ITU-T H.264/AVC standard. Under this scenario, in many embodiments, each bin associated with a particular context that is processed may result in a state change and each probability state may be associated with a particular probability estimate. The probability state changes may be specified by a predefined table, as is the case for CABAC in H.264/AVC, based upon the value of the bin just processed.

It will be appreciated that the probability estimates under these modeling processes are initially very sensitive to the assumed initial probability distribution for the source. For contexts that have relatively few symbols, the assumption may be inappropriate and may have a negative impact on compression efficiency. It will also be appreciated that the throughput is limited since the probability estimate for a given context needs to be updated after processing each bin based upon the bin value.

## *Two-pass encoding*

In delay-tolerant embodiments, a two-pass approach may be employed to improve the initial probability distribution estimate. The approach may be applied to a coding unit, or other portion or part of the data.

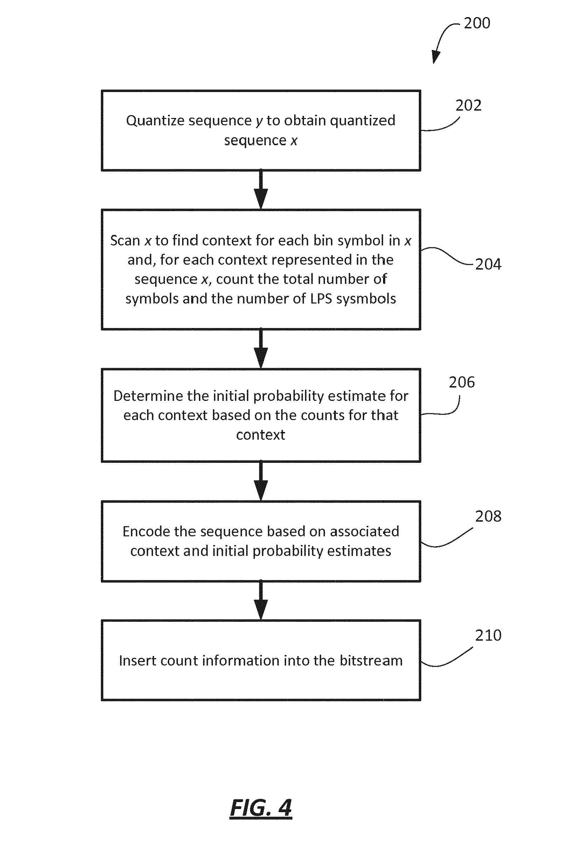

Reference will now be made to Figure 4, which shows, in flowchart format, an example process 200 for modeling and entropy encoding a binary sequence *y*. The binary sequence *y* may be a frame, slice, coding unit, a macroblock, a prediction unit, a transform unit, or other predefined portion or part of the data. The data may be video or image data in many embodiments.

In operation 202, the sequence *y* is quantized to produce a quantized sequence *x*. The quantized sequence *x* is to be entropy encoded to form part of a bitstream that will be stored or transmitted to a decoder.

The sequence *x* is scanned in operation 204 to identify a context for each bin of the sequence *x*. The context may be based upon a bit position in the sequence x or may be based on other side information. The scanning operation 204 also includes determining a count of the number of bins/symbols in the sequence x associated with each context and a count of how many of those bins/symbols are least probable symbols (LPS). It will be appreciated that this count may be implemented as a count of most probable symbols (MPS). It will also be appreciated that in some embodiments, the number of symbols for a given context in the sequence x may already be known as a set value, so the process may involve counting the MPS or LPS. Irrespective of these variants, the scanning operation 204 results in the encoder knowing how many symbols are associated with each context represented in the sequence *x* and the number of those symbols that are MPS/LPS for each context. In a binary situation, the MPS may be predetermined to be a 1 or 0 for a given implementation. In some instances, the value of the MPS may change and may be selected/specified prior to the process 200.

In operation 206, the encoder determines the initial probability estimate for each context based on the counts obtained in operation 204. For example, the initial probability estimate for a given context j may be set as $p_{0,j} = countLPS_j / countBins_j$, where $countLPS_j$ is the number of bins in the sequence that have context j and are LPS, and $countBins_j$ is the total number of bins in the sequence that have context j. It will be understood that this ratio may be used to index a set of predetermined "states" or probability values in some embodiments, rather than as an explicit initial probability calculation. For example, in many embodiments, the context model may provide for a set of predefined probability states, each probability state corresponding to a particular probability estimate, and each context may have as its "context state" one of the probability states. Finite state machines may be used in some instances to track the current context state (*i.e.* probability state) for each context.

Once the initial probability estimates are determined for each context represented in the sequence *x*, then the sequence *x* is encoded based upon those estimates in operation 208. In one implementation, the sequence *x* may be encoded using that initial probability estimate for all symbols having that context in the sequence *x*. In another implementation, the sequence *x* may be encoded using the initial probability estimate for the first bin having that context, and the probability estimate may be updated based on the value of the first bin for encoding the subsequence bin having that context, and so on. Operation 208 results in generation of an output bitstream that results from the entropy encoding of the sequence *x*.

In operation 210, after the entropy encoding of the sequence x, information is inserted into the bitstream regarding the counts obtained in operation 204 or, alternatively, regarding the initial probability estimates obtained in operation 206, to enable the decoder to entropy decode the bitstream to recover the sequence *x*. In one embodiment, the counts of LPS, MPS, or number of bins for each context are inserted. In another embodiment, the determined initial probability estimates from operation 206 are inserted. In another embodiment, the counts and/or probability estimates are specified by index to a predetermined set of counts/probabilities. Other variations will be appreciated by those skilled in the art in light of this description.

In one embodiment, the process may be represented with the following pseudo-code:

1. Quantize sequence y to obtain quantized sequence *x*.

2. For a fixed context model, losslessly compress *x* by:

2.1 Scan the sequence *x* to determine the context of each bit in x and, for each context j build a pair of non-negative integers $(m_j, n_j)$, wherein $n_j$ denotes the number of symbols in x that have context j, and $m_j$ denotes the number of 1s in *x* that have context j .

2.2 Determine a finite probability set $\{q_0, q_1, ..., q_{M-1}$ of probabilities based on the pairs $(m_0, n_0), (m_1, n_1), ..., (m_{M-1}, n_{M-1})$, where $q_j$ is from a size K ordered set $E=\{(s_0, s_1, ..., s_{K-1})$.

2.3 Encode x as follows:

(a) Encode and send E to the decoder [cost_a]

(b) Encode and send $\{q_0, q_1, ..., q_{M-1}\}$ to the decoder [cost_b]

(c) Encode each $x_i$ with probability $q_j$, where the context = j [cost_c]

In embodiments that use soft-decision quantization (SDQ), the process may be iterated to further reduce the rate distortion cost. SDQ (sometimes termed RDOQ (rate-distortion optimized quantization)) may be incorporated into the quantization step 1 above. It will be appreciated that E does not necessarily need to be sent to the decoder in operation 2.3(a) if the E is a predefined set. In some cases, however, E may be a subset of a predefined set.

In some embodiments, for a given context model and sequence x, in operation 2 the encoder may search for combination of K, E, $\{q_0, q_1, ..., q_{M-1}\}$ that minimizes the overall cost. It will be noted that there are three costs: cost_a reflects the cost of communicating the set of possible probabilities to the decoder; cost_b reflects the cost of communicating the selected set of probabilities for this particular context j for the sequence x, where those probabilities have been selected from E; and cost_c reflects the cost of communicating the encoded sequence x. It will be understood that in some embodiments cost_a may be zero if the decoder and encoder work from a predefined ordered set of probabilities from which $\{q_0, q_1, ..., q_{M-1}\}$ is selected. In some cases, E may be a subset of predefined probabilities, such as a subset of the 64 states/probabilities defined in CABAC for H.264/AVC, and cost_a may reflect the cost of communicating the subset to the decoder.

It will be understood that cost_a and cost_b reflect the "model cost", while cost_c reflects the "sequence cost". The selection of K, E, and $\{q_0, q_1, ..., q_{M-1}\}$ may be based on minimizing a total cost given by the expression:

$$\text{cost\_a} + \text{cost\_b} + \text{cost\_c} - H(m_0, n_0) - H(m_1, n_1) - ..., - H(m_{M-1}, n_{M-1})$$

Where H() is an unnormalized entropy function in which, for non-negative integers (a,b), $H(a, b) = a \log_2(b/a) + (b-a)\log_2(b/(b-a))$.

In one example embodiment, the set $\{q_0, q_1, ..., q_{M-1}\}$ is encoded for a subset of a video frame conditioned on the probability sets in the encoded history.

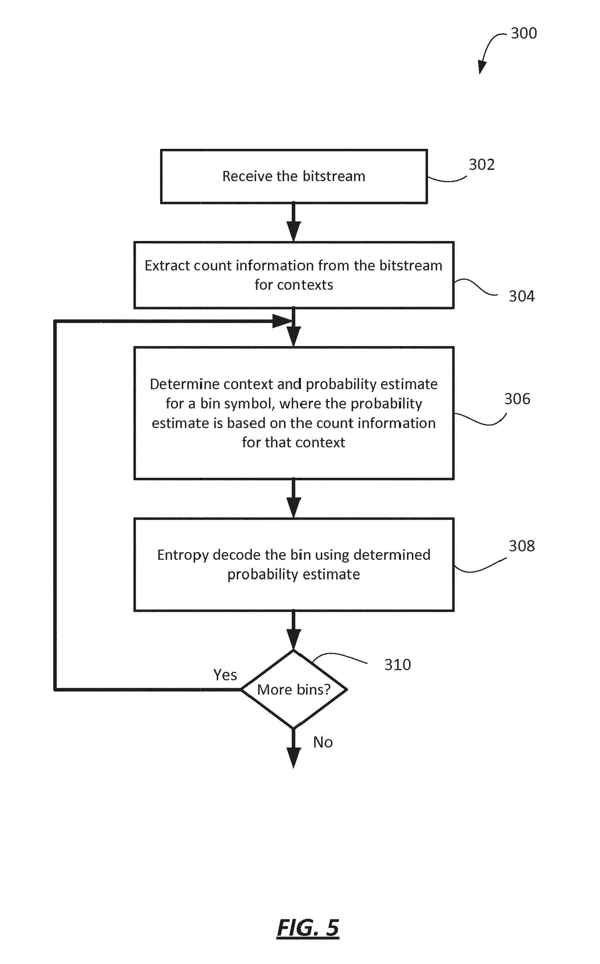

Reference is now made to Figure 5, which shows, in flowchart form, a decoding process 300. The decoding process 300 begins with receiving the bitstream in operation 302. It will be understood that the bitstream may be received over a signal path or network connection, whether wired or wireless, or retrieved from a storage medium such as a DVD, CD, magnetic or optical storage, or other computer-readable storage medium.

In operation 304, count information is extracted from the bitstream. The count information may be encoded, for example using Huffman coding or other VLCs. The count information may be in a header portion of the bitstream. The bitstream may, in some embodiments, have multiple headers. For example, in the case of video each frame or slice may have a header portion. The headers may be applied to other divisions of the video into coding units.

The count information includes information regarding the symbol counts for one or more contexts for an associated sequence. For example, the count information may include a count of most probable symbols for a given context, or least probable symbols, or both. The count information may include a total count of symbols for a given context for the sequence.

From the counter information, the decoder can determine the probability estimate used by the encoder in encoding bin symbols associated with that context for the sequence. In operation 306, the decoder determines the context for a bin symbol and the associated probability estimate (which in some cases is determined through the context state, which may be tracked using a finite state machine). The count information for that context provides the basis for determining the probability estimate or context state, at least for the initial bin symbol (subsequent bin symbols for that context may have a state or a probability estimate based upon the initial state or probability estimate adjusted by the value of the decoded initial bin for that context).

In operation 308, the determined state or probability estimate is used to entropy decode the bin symbol from the bitstream.

If further bin symbols remain to be decoded in the bitstream for the frame, slice, or other coding unit, then at operation 310 the process 300 returns to operation 306 to decode the next bin symbol.

### *One-pass encoding*

Not all embodiments will tolerate the possible delay associated with the two-pass approach. Accordingly, a one-pass approach may be more attractive for those embodiments. However, another problem with the existing one-pass approach used for CABAC in H.264/AVC is that there is a mismatch between the one-pass arithmetic encoding of CABAC and the encoding rate estimate used in soft decision quantization (SDQ) or rate-distortion optimized quantization (RDOQ). The one-pass encoding process described below may reduce that mismatch.

The one-pass encoding process described below may also reduce the model overhead.

In accordance with the present application, instead of updating the context state, i.e. probability state, with each bin symbol encoded for a given context, the probability state (and consequently the corresponding probability estimate) remains in an initial probability state determined at the beginning of a coding unit (CU), a macroblock, a prediction unit, a transform unit (TU), or other defined block of data. This change to the context modeling process within the encoding process will result in a greater consistency with the cost modeling incorporated within SDQ/RDO/RDQ.

To illustrate the change, consider an example based upon the finite state machine in CABAC as defined in H. 264/AVC. In this example illustration, an example transform unit includes five symbols (11010) that have a given context ctx. The MPS is 1. The initial probability state of context ctx is 5. The encoding of these five bin symbols is described in the table below for conventional CABAC and for the encoding process of the present application:

| bin | 1 | 1 | 0 | 1 | 0 | next TU |
|---|---|---|---|---|---|---|
| probability state for ctx | 5 | 6 | 7 | 5 | 6 | 4 |
| New encoding process | 5 | 5 | 5 | 5 | 5 | 4 |

It will be noted that in the case of conventional CABAC the probability state is updated with each bin processed based on the value of the bin and the rules of the finite state machine. In the new encoding process, the initial probability state is used for encoding all five bin symbols without updating the probability state. The probability state is updated after encoding the five bin symbols so that an updated probability state is used in encoding the next TU. It will also be noted that the update is based upon the accumulated state changes caused by the value of all the bin symbols for that ctx and the state machine.

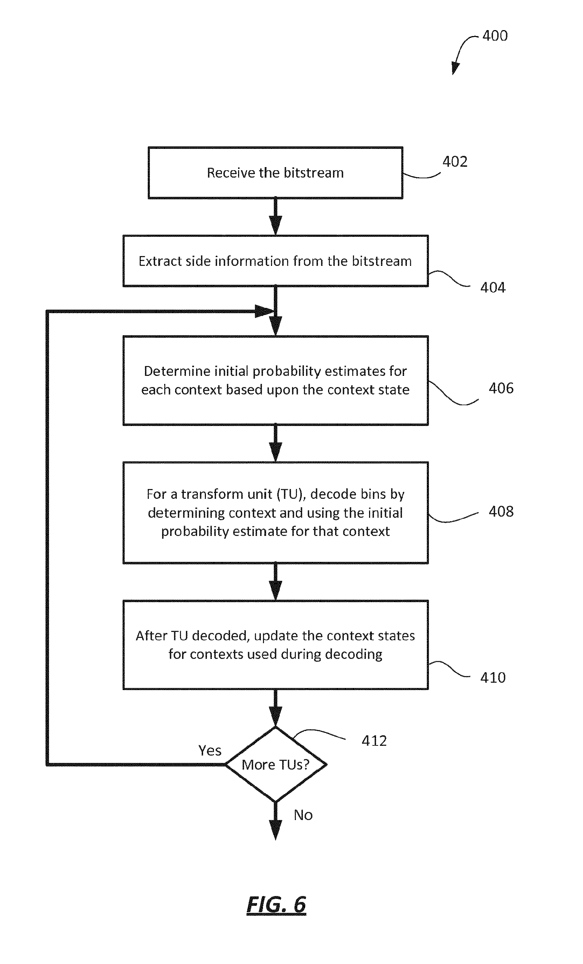

Reference is now made to Figure 6, which illustrates an example process 400 for decoding a bitstream of encoded data. The process 400 begins with receipt of the bitstream in operation 402. It will be understood that the bitstream may be received over a signal path or network connection, whether wired or wireless, or retrieved from a storage medium such as a DVD, CD, magnetic or optical storage, or other computer-readable storage medium.

In operation 404, side information may be extracted from the bitstream. This may include various flags or other parameters inserted in the bitstream by the encoder to tell the decoder how the data has been encoded. For example, the bitstream may include a flag indicating whether the conventional CABAC encoding process was used or whether the new encoding process described herein was used. In some cases, the side information may be entropy encoded, such as using VLC or other techniques, and the decoder may decode this information to obtain it. Some of the side information may be in a header portion of the bitstream. The bitstream may include more than one header in some embodiments. For example, in the case of video data, the bitstream may include a header for each frame or slice and that header may contain side information regarding the encoding parameters used for encoding that frame or slice.

The decoder decodes the information based on a fixed context model. The context model may be predetermined or may be specified in the side information.

In operation 406, the decoder determines the initial probability estimate associated with each context. In some embodiments, each context may have a probability state that corresponds to a probability estimate. In such an embodiment, operation 406 involves determining the probability state for each context. The probability state for each context may be tracked using a finite state machine in some implementations. In such a situation, the probability state may be based upon an initialized state for the state machine in the case of the first transform unit to be decoded, or may be based on the last state reached in the processing of the most recent transform unit in the bitstream.

Operation 408 involves the decoding of a transform unit. In this example, the decoding of the transform unit involves the decoding of the quantized transform domain coefficients for a transform block or sequence. The sequence is a series of bins that were encoded by the encoder based upon their context and a probability estimate (probability state). At the decoder, in operation 408, the decoder decodes the bins by deriving their context and using the initial probability state determined operation 406. The probability state for a given context is not updated within operation 408. That is, multiple bins having a given context are decoded using the same probability state without updating the probability state after processing of each bin.

In one embodiment, the decoder decodes the bins sequentially, *i.e.* in the order. In particular, for each bin in sequence the decoder derives its context and then, based on the probability state associated with the context, the decoder decodes the bin. Decoding the bin may involve determining the bin value using, for example, arithmetic decoding.

In operation 410, after the TU has been decoded, the probability states for the various contexts referenced in operation 408 are updated. The update is based upon the finite state machine defined by the context model and the values of the bins decoded for that context in operation 408.

After the probability states for those contexts have been updated, then in operation 412 the decoder determines if further TUs are to be decoded from the bitstream and, if so, loops back to operation 406.

In one example implementation for video encoding and decoding, the slice header syntax may incorporate a one-bit flag, cabac_res_state_transition_interval, to signal whether the probability state is to be updated with each bin symbol decoded or whether it should be updated only after each transform unit is decoded.

The probability state update process may be represented by the following pseudo-code:

```
for (i=0; i < lenBinArrIdx; i++)
{
    if( pBinArrIdx[i] = = valMPS )
        pStateIdx = transIdxMPS( pStateIdx )
    else {
      if( pStateIdx = = 0 )
          valMPS = 1 - valMPS
     pStateIdx = transIdxLPS( pStateIdx )
      }
}
lenBinArrIdx = 0
```

In this example pseudo-code, an array pBinArrIdx[ ] contains the values of the bins (binVal) associated with a given context and lenBinArrIdx tracks the length of pBinArrIdx[ ] as bin values are added to it during the decoding process. The length variable is then used to control the update loop, as indicated above in the pseudo-code.

The inputs include the array pBinArrIdx[ ], its length lenBinArrIdx, the current (i.e. initial) probability state for the context pStateIdx, and most probable symbol value valMPS. The output is the updated probability state given by pStateIdx and valMPS for the context variable associated with the context ctxIdx. It will be noted that the functions transIdxMPS(pStateIdx) and transIdxLPS(pStateIdx) are used to update the probability state in accordance with the finite state machine in the case of a most probable bin symbol or least probable bin symbol, respectively.

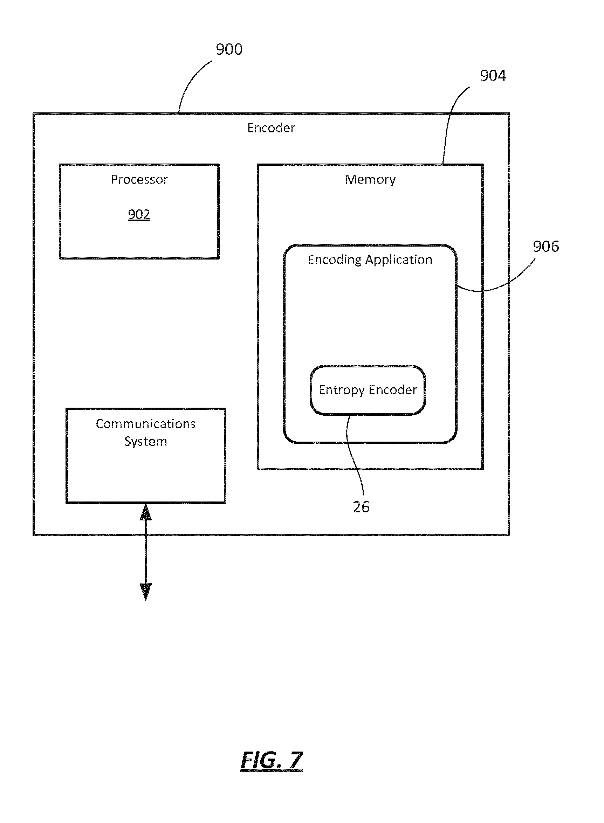

Reference now made to Figure 7, which shows a simplified block diagram of an example embodiment of an encoder 900. The encoder 900 includes a processor 902, memory 904, and an encoding application 906. The encoding application 906 may include a computer program or application stored in memory 904 and containing instructions for configuring the processor 902 to perform steps or operations such as those described herein. For example, the encoding application 906 may encode and output bitstreams encoded in accordance with the modified context-based coding order process described herein. The encoding application 906 may include an entropy encoder 26 configured to entropy encode input sequences and output a bitstream using one or more of the processes described herein. It will be understood that the encoding application 906 may be stored in on a computer readable medium, such as a compact disc, flash memory device, random access memory, hard drive, etc.

In some embodiments, the processor 902 in the encoder 900 may be a single processing unit configured to implement the instructions of the encoding application 906. It will further be appreciated that in some instances, some or all operations of the encoding application 906 and one or more processing units may be implemented by way of application-specific integrated circuit (ASIC), etc.

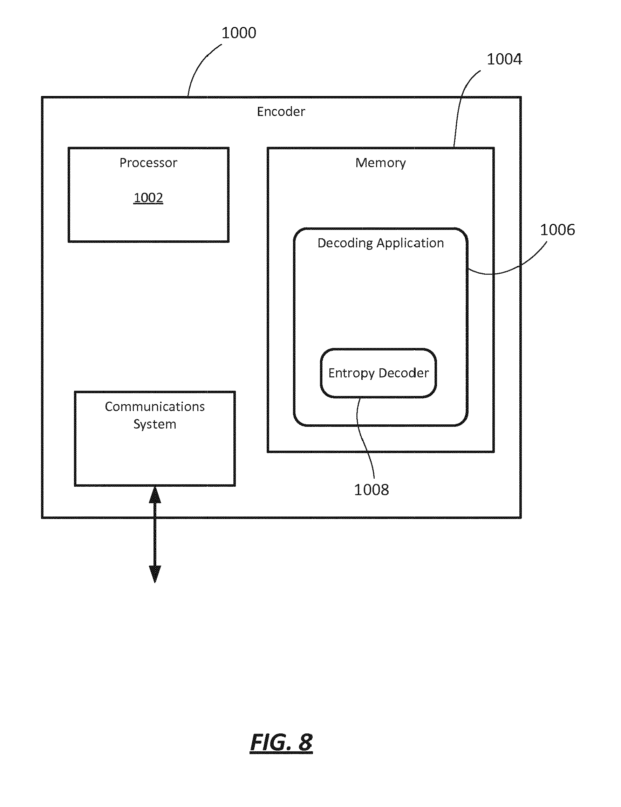

Reference is now also made to Figure 8, which shows a simplified block diagram of an example embodiment of a decoder 1000. The decoder 1000 includes a processor 1002, a memory 1004, and a decoding application 1006. The decoding application 1006 may include a computer program or application stored in memory 1004 and containing instructions for configuring the processor 1002 to perform steps or operations such as those described herein. The decoding application 1006 may include an entropy decoder 1008 configured to receive a bitstream encoded in accordance with the modified context-based coding order process described herein, and to extract encoded subsequences from the bitstream and perform multi-bit probability estimation for decoding of groups of bits having the same context, as described herein. It will be understood that the decoding application 1006 may be stored in on a computer readable medium, such as a compact disc, flash memory device, random access memory, hard drive, etc.

In some embodiments, the processor 1002 in the decoder 1000 may be a single processing unit configured to implement the instructions of the decoding application 1006. In some other embodiments, the processor 1002 may include more than one processing unit capable of executing instructions in parallel. The multiple processing units may be logically or physically separate processing units. It will further be appreciated that in some instances, some or all operations of the decoding application 1006 and one or more processing units may be implemented by way of application-specific integrated circuit (ASIC), etc.

It will be appreciated that the decoder and/or encoder according to the present application may be implemented in a number of computing devices, including, without limitation, servers, suitably programmed general purpose computers, set-top television boxes, television broadcast equipment, and mobile devices. The decoder or encoder may be implemented by way of software containing instructions for configuring a processor to carry out the functions described herein. The software instructions may be stored on any suitable computer-readable memory, including CDs, RAM, ROM, Flash memory, etc.

It will be understood that the encoder and decoder described herein and the module, routine, process, thread, or other software component implementing the described method/process for configuring the encoder may be realized using standard computer programming techniques and languages. The present application is not limited to particular processors, computer languages, computer programming conventions, data structures, other such implementation details. Those skilled in the art will recognize that the described processes may be implemented as a part of computer-executable code stored in volatile or non-volatile memory, as part of an application-specific integrated chip (ASIC), etc.

Certain adaptations and modifications of the described embodiments can be made. Therefore, the above discussed embodiments are considered to be illustrative and not restrictive.

**Claims**

1. A method for decoding a bitstream of encoded video data based on count information in a video decoder, wherein the encoded video data has been encoded in accordance with a context model that defines a plurality of contexts, the method comprising:

   obtaining information from the bitstream regarding a count of symbols for each context represented in a sequence of bits; and
   reconstructing the sequence of bits by, for each bit,
   determining a context and a probability estimate, wherein the probability estimate is based upon the count of symbols for that context, and
   entropy decoding that bit from the bitstream using the determined context and the determined probability estimate.

2. The method of claim 1, wherein the count of symbols comprises a count of least probable symbols or a count of most probable symbols.

3. The method of claim 1 or claim 2, wherein determining a probability estimate for that context comprises determining an initial probability estimate for that context based upon the count of symbols for that context, and wherein entropy decoding comprises using the initial probability estimate for decoding each bit in the sequence having that context.

4. The method of claim 1 or claim 2, wherein determining a probability estimate for that context comprises determining an initial probability estimate for that context based upon the count of symbols for that context, and wherein entropy decoding comprises using the initial probability estimate for decoding the first bit in the sequence having that context, updating the initial probability estimate based on the decoded first bit, and using the updated initial probability estimate for a next bit in the sequence having that context.

5. The method of claim 1 or claim 2, wherein determining a probability estimate for that context comprises initially determining the probability estimate for that context based upon the count of symbols for that context, and wherein entropy decoding further comprises:

   for each bit in the sequence having that context,

entropy decoding that bit using the probability estimate, and
updating the probability estimate based on the entropy decoded bit prior to decoding a next bit in the sequence having that context.

6. The method of any one of claims 1 to 5, wherein the sequence of bits corresponds to one of a frame, a slice, a coding unit, and a transform unit.

7. The method of any one of claims 1 to 6, wherein obtaining comprises decoding the count of symbols from a header portion of the bitstream associated with the sequence of bits.

8. A method for encoding video data in a video encoder using a context model that defines a plurality of contexts, the method comprises:

for a sequence of bits from the video data,
determining a context for each bit in the sequence of bits;
determining a count of symbols for each context represented in the sequence of bits;
entropy encoding each bit using its context and a probability estimate based on the count of symbols for that context to produce a bitstream of encoded data; and
inserting information in the bitstream regarding the count for each context within the sequence of bits.

9. A decoder for decoding a bitstream of encoded data that has been encoded in accordance with a context model that defines a plurality of contexts, the decoder comprising:

a processor;
a memory; and
a decoding application stored in memory and containing instructions for configuring the processor to decode the bitstream by performing the method claimed in any one of claims 1 to 7.

10. An encoder for encoding data in accordance with a context model that defines a plurality of contexts, the encoder comprising:

a processor;
a memory; and
an encoding application stored in memory and containing instructions for configuring the processor to encode the data by performing the method claimed in claim 8.

11. A method for decoding a bitstream of encoded data that has been encoded in accordance with a context model that defines a plurality of contexts, each context having a probability state, each bin of the encoded data having been encoded based upon its associated context and the probability state of that context, the method comprising:

for a part of the bitstream having a plurality of bins,
decoding each bin in the part by
deriving the context associated with the bin, and
decoding the bin using the probability state of the context; and
updating the probability state of each context based on the decoded bins associated with that context.

12. The method claimed in claim 11, wherein updating generates an updated probability state for each context, and wherein the updated probability states are used for decoding a next part of the bitstream.

13. The method claimed in claim 11 or claim 12, wherein each context has an initial probability state at the beginning of decoding the part of the bitstream, and wherein decoding the bin using the probability state of the context comprises decoding the bin using the initial probability state of the context.

14. The method claimed in any one of claim 11 to 13, wherein updating comprises applying a state transition specified by a finite state machine for each decoded bin associated with that context, and wherein each state transition applied to the probability state to update the probability state is based upon the value of the decoded bin associated with that context.

**15.** A method for decoding a bitstream of encoded data that has been encoded in accordance with a context model that defines a plurality of contexts, each context having a set of probability states, each bin of the encoded data having been encoded based upon its associated context and one of the probability states for that context, the method comprising:

for a current part of the bitstream, and for a context associated with a plurality of bins contained in the current part, determining an initial probability estimate based upon an initial probability state for that context;

decoding the current part using the initial probability state to reconstruct the bins associated with that context; and

updating the initial probability state of the context based on the reconstructed bins associated with that context to produce an updated probability state.

**FIG. 1**

*FIG. 2*

100

106

102

$x$ → Context Modeling Component

$b_0, b_1, b_2, b_3, ..., b_n$

$p_0, p_2, p_0, p_1, ..., p_k$

Entropy Coder

104

**_FIG. 3_**

200

202

Quantize sequence *y* to obtain quantized sequence *x*

204

Scan *x* to find context for each bin symbol in *x* and, for each context represented in the sequence *x*, count the total number of symbols and the number of LPS sysmbols

206

Determine the initial probability estimate for each context based on the counts for that context

208

Encode the sequence based on associated context and initial probability estimates

210

Insert count information into the bitstream

## FIG. 4

300

Receive the bitstream — 302

Extract count information from the bitstream for contexts — 304

Determine context and probability estimate for a bin symbol, where the probability estimate is based on the count information for that context — 306

Entropy decode the bin using determined probability estimate — 308

More bins? — 310

Yes

No

*FIG. 5*

400

Receive the bitstream — 402

↓

Extract side information from the bitstream — 404

↓

Determine initial probability estimates for each context based upon the context state — 406

↓

For a transform unit (TU), decode bins by determining context and using the initial probability estimate for that context — 408

↓

After TU decoded, update the context states for contexts used during decoding — 410

↓

Yes — More TUs? — 412

No

↓

*FIG. 6*

900

904

Encoder

Processor

902

Memory

906

Encoding Application

Entropy Encoder

26

Communications
System

**FIG. 7**

1000

1004

## Encoder

### Processor

1002

### Memory

#### Decoding Application

1006

##### Entropy Decoder

1008

### Communications System

## FIG. 8

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 61495772 A